# EUROPÄISCHE PATENTSCHRIFT

(11) **EP 3 711 099 B1**
(45) Veröffentlichungstag und Bekanntmachung des Hinweises auf die Patenterteilung: **18.03.2026**
(21) Anmeldenummer: 18789388.8
(22) Anmeldetag: 17.10.2018
(51) Int. Cl.: H01L 23/31, H10D 30/47, H10D 62/85

(54) **GATE-STRUKTUR UND VERFAHREN ZU DEREN HERSTELLUNG**
GATE STRUCTURE AND METHOD FOR PRODUCING SAME
STRUCTURE DE GRILLE ET SON PROCÉDÉ DE FABRICATION

(30) Priorität: 17.11.2017 DE 102017127182
(43) Veröffentlichungstag der Anmeldung: 23.09.2020
(73) Patentinhaber: Ferdinand-Braun-Institut gGmbH, Leibniz-Institut für Höchstfrequenztechnik, 12489 Berlin (DE)
(72) Erfinder: OSIPOV, Konstantin, 12353 Berlin (DE); WÜRFL, Hans-Joachim, 15738 Zeuthen (DE)
(74) Vertreter: Gulde & Partner
(86) Internationale Anmeldenummer: PCT/EP2018/078408
(87) Internationale Veröffentlichungsnummer: WO 2019/096528

(56) Entgegenhaltungen:
- JP-A- 2008 244 001
- NAOTERU SHIGEKAWA ET AL: "Analysis of Passivation-Film-Induced Stress Effects on Electrical Properties in AlGaN/GaN HEMTs", IEICE TRANSACTIONS ON ELECTRONICS, INSTITUTE OF ELECTRONICS, TOKYO, JP, vol. E93C, no. 8, August 2010 (2010-08-01), pages 1212 - 1217, XP001558270, ISSN: 0916-8524, DOI: 10.1587/TRANSELE.E93.C.1212

## Beschreibung

Die vorliegende Erfindung betrifft eine Gate-Struktur (d. h. eine Transistor-Struktur mit einem zugehörigen Gate-Bereich) sowie ein Verfahren zu deren Herstellung. Insbesondere betrifft die vorliegende Erfindung eine Gate-Strukturierung eines Feldeffekttransistors (FET) als Verarmungstyp (englisch "depletion type" oder "D-type").

### Stand der Technik

Als Gate (englisch für "Tor", "Gatter") wird insbesondere bei Feldeffekttransistoren (FET) der zur Ansteuerung des FET verwendete Anschluss bezeichnet. Weitere Anschlüsse sind Source (englisch für "Quelle") und Drain (englisch für "Senke"). Durch Variation der am Gate anliegenden Spannung kann der Stromfluss zwischen Drain und Source gesteuert werden. Die einzelnen Anschlüsse ermöglichen eine elektrische Kontaktierung des Schaltelements und führen als Elektroden die zugeführten Spannungen und Ströme in den aktiven Schaltbereich. Daher wird der Gate-Anschluss auch als Steuerelektrode bzw. Steueranschluss bezeichnet. Der strukturelle Aufbau des Gate-Anschlusses und dessen Einbettung in das zugehörige Schaltelement wird dabei als Gate-Struktur bezeichnet.

Aus der US 2002/0048858 A1 ist eine T-förmige Gate-Struktur, ein sogenanntes T-Gate, bekannt. Als T-Gate wird darin der leitfähige Gate-Bereich eines Halbleiterbauelements (z.B. Metall-Halbleiter-Feldeffekttransistor (englisch "metal semiconductor field effect transistor" - MeSFET), Transistor mit hoher Elektronenbeweglichkeit (englisch "high electron mobility transistor" - HEMT), etc.) bezeichnet, dessen oberer Bereich breiter ist als der Bereich an der Basis (d.h. in unmittelbarem oder über einen Gate-Isolator getrennten Kontakt zum aktiven Bereich des Halbleiterbauelements). Der Vorteil einer solchen Anordnung liegt darin, dass über den schmalen Bereich des Gates im Halbleiterbauelement eine extrem kurze Kanallänge realisiert werden kann, wodurch hohe Betriebsfrequenzen und eine hohe Transkonduktanz (deutsch "Steilheit") erreicht werden können, während über den breiteren oberen Gate-Bereich eine hohe Leitfähigkeit des T-Gate hohe Schaltgeschwindigkeiten ermöglicht (durch praktisch verlustfreies Auf- und Entladen der Gate-Kapazität).

In der US 5,053,348 A wird ein Verfahren zur Herstellung eines selbstjustierenden T-Gate HEMT offenbart. Die US 2013/0105817 A1 offenbart ebenfalls einen HEMT mit einer T-Gate-Struktur. Ein dehnungsausgeglichener Nitrid-Heterojunction-Transistor (HFET) ist aus der US 7,030,428 B2 bekannt. Aus der US 2017/0133471 A1 sind ein Power-FET und ein Verfahren zu dessen Herstellung bekannt. Cho et al. offenbaren HEMT in AlGaN/GaN mit geringen Leckströmen im Sperrzustand (Cho, S.-J. et al., "Low off-state Leakage Currents in AlGaN/GaN High Electron Mobility Transistors By Employing A Highly Stressed SiNx Surface Passivation Layer", WoDIM, 27.-30. Juni 2016). Die JP 2008 244001 A offenbart eine Nitrid-Halbleitervorrichtung mit geringem Gate-Leckstrom. Shigekawa et al. betrifft eine Untersuchung zu durch Passivierungsfilme induzierten Stresseffekten auf die elektrischen Eigenschaften von AlGaN/GaN-HEMTs (Shigekawa, N. and Suehiro, S., "Analysis of passivation-film-induced stress effects on electrical properties in AlGaN/GaN HEMTs", IEICE Transactions on Electronics 93(8), 2010).

Insbesondere bei den sogenannten Kurzkanal-HFETs kann bei stark verkürzten Gate-Längen das Sperrfeld des Schottky- oder MIS-Kontaktes nicht mehr ausreichen, den durch den Kanal fließenden Strom zu steuern. Typischerweise werden daher im Stand der Technik lokale Gate-Aussparungen im Halbleitermaterial oder andere Methoden genutzt, welche entweder eine lokale Reduzierung der Elektronendichte unterhalb des Gates bewirken oder welche es erlauben, das Gate physikalisch näher an den Kanalbereich des FET heranzubringen. Dadurch wird jedoch auch stets die Elektronendichte unterhalb des Gates im Ein-Zustand negativ beeinflusst.

Ein weiteres Problem im Zusammenhang mit der effektiven Elektronendichte unterhalb des Gates tritt bei der Entwicklung von selbstsperrenden HEMT bzw. HFET auf. Typischerweise muss bei diesen ein optimaler Kompromiss zwischen einem möglichst niedrigem Durchlasswiderstand (englisch "on-resistance") und der Höhe der Abschnürspannung (englisch "pinch-off voltage") des Transistors eingestellt werden. Eine Methode zur Abstimmung basiert auf der Verarmung des unmittelbaren Bereichs unterhalb des Gates durch das elektrische Feld einer Schottky-Barriere. Dafür muss der Gate-Anschluss sehr nahe an das 2DEG herangeführt werden, so dass die sich intrinsisch ausbildende Raumladungszone in der Lage ist, das 2DEG bei 0 V Gate-Spannung zu verarmen - der Transistor sperrt. Diese Änderung der Kanalgeometrie reduziert die maximal mögliche Elektronenkonzentration unmittelbar unter dem Gate, erhöht die Gate-Kapazität signifikant und führt zu weitaushöheren elektrischen Feldern in unmittelbarer Nähe der Gate-Elektrode was wiederum ein Zuverlässigkeitsproblem darstellt. Zur Heranführung der Gate-Elektrode werden daher analog zu Kurzkanal-HFETs lokale Gate-Aussparungen im Halbleitermaterial genutzt oder es werden aufwendig zu strukturierende p-Gate-Strukturen eingesetzt. Nachteilig an diesen Verfahren ist jedoch, dass auch hierbei wiederrum die Elektronendichte unterhalb des Gates im Ein-Zustand des Transistors und die Gate-Kapazität negativ beeinflusst wird.

Bei FETs unterscheidet man im Wesentlichen zwischen einem Verarmungstyp (englisch "depletion type" oder "D-type") und einem Anreicherungstyp (englisch "enhancement type" oder "E-type"). Transistoren vom Verarmungstyp (D-Transistoren) sind i.d.R. selbstleitend (englisch "normally-on"). Transistoren vom Anreicherungstyp (E-Transistoren) sind i.d.R. selbstsperrend (englisch "normallyoff"). Diese Transistoren aufgrund ihrer geringen parasitären Widerstände beispielsweise als HF-Leistungstransistoren in Leistungsverstärkern (englisch "power amplifier" oder PA) eingesetzt. Für die Realisierung von integrierten elektronischen Logik-Schaltkreisen ist es bevorzugt, beide Transistortypen auf einem gemeinsamen Substrat zu strukturieren und somit herstellen zu können. Eine solche Kombination gestaltet sich jedoch oft schwierig, da sich die beiden Transistortypen im Allgemeinen sowohl in ihrem inneren Aufbau und als auch in ihren elektrischen Eigenschaften unterscheiden. Insbesondere die Integration von selbstsperrenden und selbstleitenden Transistoren auf einem gemeinsamen epitaktischen Wafer stellt eine besondere prozesstechnologische Herausforderung dar.

Typischerweise werden für eine solche E/D-Integration zunächst die epitaktischen Strukturen für die selbstleitenden D-Transistoren aufgewachsen und anschließend während des eigentlichen Strukturierungsprozesses der Bereich unterhalb des Gates mittels geätzter Gate-Aussparungen oder durch Ionenimplantation im Halbleitermaterial zur lokalen Änderung der elektronischen Eigenschaften lokal modifiziert. Solche Modifikationen der elektronischen Eigenschaften erlauben eine Reduzierung der Elektronendichte innerhalb des Leitungskanals und erhöhen zusätzlich die Gate-Kapazität. In Kombination mit der Verarmungszone einer Schottky- oder MIS-Strukturierung des Gate-Bereichs kann dies zu einem selbstsperrenden Verhalten des erzeugten Transistors führen (E-Transistor). Insbesondere eine lokale Ionenimplantation ist dabei jedoch sehr zeit- und kostenintensiv. Weiterhin führen diese integrativen Maßnahmen ebenfalls dazu, dass die Elektronendichte unterhalb des Gates im Ein-Zustand des Transistors negativ beeinflusst werden kann und sich auf jeden Fall die Gate-Kapazität und das elektrische Feld in der Nähe des Gates erhöht.

Neben den bisher genannten FETs vom Anreicherungs- und Verarmungstyp lässt sich über die Elektronendichte in der aktiven Schicht ein weiterer Transistortyp abgrenzen, bei dem das Steilheitsmaximum im Schaltverhalten bei einer Gate-Spannung U_{GS} von 0 V auftritt (LN-Typ bzw. Neutraltyp). Der LN-Transistor eignet sich insbesondere für den Aufbau rauscharmer Verstärkerschaltungen (englisch "low noise amplifier" oder LNA).

Insbesondere im Bereich der monolithisch integrierten Mikrowellenschaltkreise (MMICs) ist es wünschenswert sowohl Leistungstransistoren als auch rauscharme Kleinsignaltransistoren monolithisch auf einem Substrat zu integrieren. Diese Fähigkeit würde es ermöglichen, Sende und Empfängerbausteine (Transceiver) auf einem gemeinsamen Chip, d.h. auf einer gemeinsamen Substrat- bzw. Epitaxiebasis, zu integrieren. Beide Transistortypen unterscheiden sich normalerweise im Aufbau. Der Leistungstransistor (englisch "power amplifier" oder PA) wird in der Regel in selbstsperrend ausgeführt, während der rauscharme Transistor ein neutrales Schaltverhalten aufweisen soll. Auch diese Integrationstechnologie (PA/LNA-Integration) erfordert ähnliche technologische Schritte wie oben dargestellt. Im Übrigen ist jedoch für komplexe Schaltungsanordnungen auch die Möglichkeit einer Integration aller bisher genannten Transistortypen auf einer gemeinsamen Substrat- bzw. Epitaxiebasis (E/D/LN-Integration) durchaus wünschenswert. Hierbei könnten beispielsweise neben dem eigentlich Transceiver auch entsprechende Logik-Schaltkreise zur direkten Verarbeitung und Umwandlung der übertragenen Signale auf dem Chip mit integriert werden.

Für viele Mikrowellenanwendungen sind auch selbstsperrende Transistoren von hohem Interesse, da sie die Komplexität des Schaltungsdesigns deutlich reduzieren. Bislang wurden diese selbstsperrende Konzepte in der Regel nicht eingesetzt, da konventionelle Technologien zu Transistoren mit einem signifikant reduzierten Maximalstrom und eine deutlich erhöhte Gate-Kapazität führen. Diese Eigenschaften reduzieren die Grenzfrequenzen und verschlechtern damit die Mikrowelleneigenschaften.

### Offenbarung der Erfindung

Es ist daher eine Aufgabe der vorliegenden Erfindung, eine alternative Gate-Struktur (d. h. eine Transistor-Struktur mit einen zugehörigen Gate-Bereich) anzugeben, welche die beschriebenen Nachteile des Standes der Technik überwindet oder zumindest deutlich reduziert. Insbesondere soll eine Gate-Strukturierung eines Feldeffekttransistors angegeben werden, welche bei gleicher aktiver Schicht einen gemeinsamen Aufbau von Transistoren des Verarmungstyps, des Anreicherungstyps und/oder als rauscharmer Typ auf einer gemeinsamen Substratbasis in einem einheitlichen Verfahren erlaubt. Allgemein soll somit die Integration von Transistoren mit variabler, durch die Technologie und nicht durch die Epitaxie vorgegebener, Schwellenspannung ermöglicht werden. Die getroffenen Maßnahmen zur Ausbildung der Gate-Struktur sollen keinen oder nur einen geringen Einfluss auf die Elektronendichte unterhalb des Gates im Ein-Zustand des Transistors haben, d.h. die Elektronenpopulation in den Bereichen zwischen Source und Gate sowie zwischen Gate und Drain soll von die Wahl der Schwellenspannung komplett entkoppelt sein. Mithin wird ein FET und ein Verfahren zur Herstellung eines solchen FET offenbart, wobei der erfindungsgemäße FET und das Verfahren zur Herstellung eines solchen FET eine entsprechende Gate-Strukturierung (Gate-Struktur und Verfahren zur Herstellung) aufweisen.

Diese Aufgaben werden erfindungsgemäß durch die Merkmale der Patentansprüche 1 und 2 gelöst.

Eine erfindungsgemäße Gate-Struktur (Transistor-Struktur) umfasst als Grundlage ein Substrat; eine piezoelektrische aktive Schicht mit einem Heteroübergang, die auf dem Substrat angeordnet ist; eine dielektrische Passivierungsschicht, die auf der aktiven Schicht angeordnet ist und eine Dicke zwischen 10 nm und 1000 nm aufweist, wobei die Passivierungsschicht eine Ausnehmung aufweist, die sich durch die gesamte Passivierungsschicht hindurch in Richtung der aktiven Schicht erstreckt, wobei die Ausnehmung an der Grenze zur aktiven Schicht eine Breite zwischen 10 nm und 500 nm aufweist; ein Gate-Kontaktelement, das innerhalb der Ausnehmung angeordnet ist, wobei das Kontaktelement sich von der aktiven Schicht bis oberhalb der Passivierungsschicht erstreckt; eine Zwischenschicht, wobei die Zwischenschicht zwischen dem Kontaktelement und der Passivierungsschicht ausgebildet ist; und eine Deckschicht, die das Kontaktelement oberhalb der Passivierungsschicht überdeckt; wobei mindestens eine oberhalb der aktiven Schicht angeordnete Schicht im Bereich um das Kontaktelement zug- oder druckverspannt mit einer Normalspannung |σ| > 200 MPa ausgebildet ist, wobei über die einzelnen Verspannungen im Bereich um das Kontaktelement eine resultierende Kraft an der Grenzfläche zwischen Passivierungsschicht und aktiver Schicht eingestellt ist, welche über den piezoelektrischen Effekt die Elektronendichte in der aktiven Schicht im Bereich unterhalb des Kontaktelements beeinflusst, wobei die Normalspannungen verspannter Schichten im Bereich zwischen ±4 GPa liegen; und das Verhältnis zwischen der Dicke der Passivierungsschicht und der Breite der Ausnehmung an der Grenze zur aktiven Schicht zwischen 1,5:1 und 4:1 beträgt.

Vorzugsweise besteht das Substrat aus SiC. Ebenfalls bevorzugt sind Substrate aus Si, Saphir, GaN und AIN.

In der aktiven Schicht finden die wesentlichen elektrischen Schalt- und Leitungsvorgänge statt. Die aktive Schicht kann eine Vielzahl unterschiedlich strukturierter Bereiche oder Zonen aus verschieden Halbleitermaterialien mit variabler Dotierung aufweisen. Vorzugsweise kann die aktive Schicht AlGaN/GaN als Halbleitermaterial umfassen. Als weitere bevorzugte Materialkomposite können AIN/GaN, InAIN/GaN und andere ternäre oder quaternäre Verbindungen von Al, N, In und Ga eingesetzt werden. In binären Kompositen kann der jeweilige Materialanteil zwischen 0% und 100% liegen. Die aktive Schicht umfasst mindestens ein piezoelektrisches Material, welches bei Verformung zu einer Änderung der elektrischen Polarisation des Materials führt.

Als Passivierungsschicht wird insbesondere eine passive Schicht bezeichnet, welche die aktive Schicht an ihrer vom Substrat abgewandten Seite räumlich und funktional begrenzt. Passiv bedeutet hierbei, dass diese Schicht keinen oder nur einen geringen Einfluss auf den Ladungstransport innerhalb des Schaltelements ausübt. Ein typisches Beispiel für eine Passivierungsschicht ist eine dielektrische Passivierungsschicht, vorzugsweise aus SiNₓ. Ebenfalls bevorzugt umfasst eine solche Passivierungsschicht SiOₓ, SiNₓO_{y}, Al₂O₃, ZnO, Fluorosilicatglas (FSG), Benzozyclobuten (BCB) oder Polyimide (PI). Bei der Passivierungsschicht kann es sich auch um eine Abstandsschicht (englisch "spacer layer") handeln. Die bevorzugte Dicke der Passivierungsschicht liegt zwischen 10 nm und 1000 nm.

Die Passivierungsschicht kann in einem nicht von den Ansprüchen umfassten Beispiel als hochgradig druck- oder zugverspannte (englisch "compressively or tensile stressed") dielektrische Schicht mit einer Normalspannung |σ| > 1 GPa ausgebildet sein. Insbesondere kann die Passivierungsschicht eine auf der gesamten Oberfläche der aktiven Schicht ausgebildete Grundschicht für alle darauffolgenden Strukturierungsschritte darstellen, wobei alle auf einen den Wafer aufgebrachten erfindungsgemäßen Gate-Strukturen auf Grundlage dieser Passivierungsschicht aufgebaut werden. Beispielsweise können bei einem Verfahren zur Herstellung integrierter Strukturen die aktive Schicht und eine darauf angeordnete hochgradig druck- oder zugverspannte Passivierungsschicht flächig auf das Substrat aufgetragen werden und als Ausgangsbasis für die Herstellung einer Vielzahl von erfindungsgemäßen Gate-Strukturen dienen.

Innerhalb der Passivierungsschicht ist erfindungsgemäß eine Ausnehmung angeordnet, die sich durch die gesamte Passivierungsschicht hindurch in Richtung der aktiven Schicht erstreckt. Bei dieser Ausnehmung handelt es sich um einen sogenannten Gate-Graben (englisch "gate trench"; auch als Gate-Loch oder Gate-Via bezeichnet), der einen elektrischen Zugriff auf die aktive Zone durch die Passivierungsschicht hindurch erlaubt. In dieser Öffnung innerhalb der Passivierungsschicht ist ein Kontaktelement angeordnet. Die Ausnehmung weist an der Grenze zur darunter liegenden Schicht eine Breite zwischen 10 nm und 500 nm auf. Der Anstellwinkel der Seitenwände der Ausnehmung liegt bevorzugt zwischen 90° und 30°, wobei bei einem Winkel von 90° die Seitenwand der Ausnehmung senkrecht auf der darunter liegenden Schicht stehend angeordnet ist.

Das Kontaktelement ist innerhalb der Ausnehmung angeordnet und erstreckt sich von der aktiven Schicht bis oberhalb der Passivierungsschicht. Bevorzugt handelt es sich bei einer erfindungsgemäßen Gate-Struktur um ein T-Gate, wobei das Kontaktelement T-förmig ausgebildet ist. T-förmig wird dabei im Allgemeinen sehr breit interpretiert, insbesondere werden solche Strukturen oftmals auch als pilz-, pfeil- oder nietenförmig bezeichnet. Beliebige andere Ausbildungen des Kontaktelements im Rahmen dieser Offenbarung sind ebenfalls möglich.

Das Kontaktelement kann aus einem Schottky-Metall aufgebaut sein. Vorzugsweise handelt es sich hierbei um Ir. Ebenfalls bevorzugt sind Pt, Ni, Al, Os, TiW und WSi.

Unter dem Gate-Metall kann sich auch ein Gate-Isolator befinden der vorzugsweise aus Al₂O₃, SiNₓ, SiOₓ, SiNₓO_{y}, HfO₂ oder anderen dielektrischen Schichten besteht. Eine bevorzugte Dicke der Isolationsschicht liegt zwischen 5 nm und 40 nm.

Vorzugsweise ist das Kontaktelement im seinem oberen Bereich vollständig von der dielektrischen Deckschicht umgeben. Die Deckschicht kann insbesondere in den an das Kontaktelement angrenzenden Bereichen unmittelbar auf der Passivierungsschicht aufliegen und das Kontaktelement von oberhalb überdecken. Bei der dielektrischen Deckschicht kann es sich bevorzugt um SiNₓ handeln. Ebenfalls bevorzugt sind SiOₓ, SiNₓO_{y}, Al₂O₃, ZnO, Fluorosilicatglas (FSG), Benzozyclobuten (BCB) und Polyimide (PI). Die Dicke der Deckschicht beträgt vorzugsweise zwischen 10 nm und 1000 nm.

Im Stand der Technik werden die auf der aktiven Schicht aufliegenden Schichten möglichst verspannungsfrei aufgebracht. Hierdurch sollen insbesondere die negativen Effekte von mechanischen Verspannungen (potentiell verringerte Lebensdauer des Transistors, Migrationseffekte, Einflüsse auf den elektrischen Ladungstransport) verhindert und ein einheitlicher Materialauftrag erreicht werden. Demgegenüber ist erfindungsgemäß mindestens eine oberhalb der aktiven Schicht angeordnete Schicht im Bereich um das Kontaktelement zug- oder druckverspannt mit einer Normalspannung |σ| > 200 MPa ausgebildet. Eine solche Verspannung kann, z.B. in der Passivierungsschicht, insbesondere dadurch erreicht werden, dass beim Aufwachsen der Passivierungsschicht auf die aktive Schicht der Verspannungszustand durch die Wahl der Prozessparameter innerhalb gewisser Grenzen einstellbar ist.

Moderne CVD-Prozesse wie sie aus der Silizium-Technologie bekannt sind erlauben es, druck- oder zugverspannte (d.h. kompressiv oder tensil verspannte) Filme im Bereich zwischen ±2 GPa herzustellen. Mit speziellen Passivierungsschichten wie z.B. CVD-Diamantschichten können noch weitaus höhere Verspannungen bis in den Bereich von ±4 GPa erreicht werden. Bei diesen Werten befindet man sich zum Teil schon im Bereich der durch die Gitterfehlanpassung von GaN auf AlGaN verursachten tensilen Verspannung (Zugverspannung) einer AlGaN-Barriere auf nicht verspanntem, d.h. spannungsfreiem, GaN. Bei einer Al-Konzentration von 30% liegt die tensile Verspannung einer solchen Schicht bei etwa 3 GPa. Eine auf die aktive Schicht aufgebrachte und sehr stark druckverspannte Passivierungsschicht ist daher dazu in der Lage, die piezoelektrische Komponente des Polarisationsvektors in der aktiven Schicht zu eliminieren oder sogar zu invertieren.

Die Stärke der Verspannung einer Schicht lässt sich über die gewählten Prozessparameter bei deren Erzeugung einstellen. Zur Kalibrierung des Verfahrens werden zunächst unterschiedliche Schichten jeweils auf einem eigenen Testwafer aufgetragen und über die Verbiegung des Wafers anschließend die durch die jeweiligen Prozessparameter erzeugte Verspannung bestimmt. Es ist jedoch auch möglich, die Verspannung einer Schicht direkt zu bestimmen. Ein geeignetes Verfahren hierzu ist fibDAC (D. Vogel, I. Maus and B. Michel, "fibDAC stress relief - A novel stress measurement approach with high spatial resolution", 3rd Electronics System Integration Technology Conference ESTC, Berlin, 2010, pp. 1-5).

Es ist möglich, dass auch bei eigentlich verspannungsfreien aufgebrachten Schichten aufgrund von Herstellungs- und Materialtoleranzen auch diese geringfügig verspannt sein können. Daher werden Schichten mit einer Normalspannung |σ| ≤ 200 MPa noch als verspannungsfrei bezeichnet. Schichten mit einer Normalspannung 200 MPa < |σ| ≤ 1 GPa werden hingegen als moderat verspannt und Schichten mit einer Normalspannung |σ| > 1 GPa werden als hochgradig verspannt bezeichnet. Bei zugverspannten Schichten ist die Normalspannung positiv, bei druckverspannten negativ.

Die angegebenen Werte für die Verspannung (mechanische Spannung) beziehen sich vorzugsweise auf das arithmetische Mittel der lokalen Verspannungswerte einer Schicht in der Umgebung des Gates. Die lokalen Verspannungswerte ergeben sich vorzugsweise aus den vektoriell addierten lokalen Normalspannungen für verschiedene Richtungen innerhalb einer Schicht (z.B. für die drei Normalspannungskomponenten σₓₓ, σ_{yy}, σ_{zz}). Vorzugsweise werden dabei ausschließlich Normalspannungskomponenten parallel zur aktiven Schicht berücksichtigt und diese über die Schichttiefe arithmetisch gemittelt. Vorzugsweise weisen die lokalen Verspannungen einer Schicht zumindest in der Umgebung des Gates einheitliche Größe und Richtung auf, d.h. die Verspannung der Schicht entspricht (zumindest in der Umgebung des Gates) an jeder Stelle dem lokalen Verspannungswert. Als Umgebung des Gates wird ein unmittelbar an das Gate angrenzender, d.h. das Gate umgebender Raumbereich, z.B. innerhalb einer Schicht, bezeichnet. Vorzugsweise entspricht eine Ausdehnung dieser Umgebung in einer die Ausnehmung in der Passivierungsschicht mittig einschließenden Ebene maximal dem 2-fachen, bevorzugter maximal dem 3-fachen, bevorzugter maximal dem 5-fachen, und noch bevorzugter maximal dem 10-fachen des Flächeninhalts der Ausnehmungsgröße. Eine in der Umgebung des Gates definierte Eigenschaft kann sich jedoch auch über diese als Umgebungsbereich bestimmte Ausdehnung hinaus erstrecken.

Die Passivierungsschicht weist eine Dicke zwischen 10 nm und 1000 nm auf. Die Ausnehmung weist an der Grenze zur darunter liegenden Schicht eine Breite zwischen 10 nm und 500 nm auf. Das Verhältnis zwischen diesen beiden Parametern (Aspektverhältnis von Dicke zu Breite) liegt zwischen 1,5:1 und 4:1, bevorzugt zwischen 1,75:1 und 2,25:1 und bevorzugter zwischen 1,9:1 und 2,5:1. Beispielsweise kann die Passivierungsschicht eine Dicke zwischen 275 nm und 325 nm und die Ausnehmung an der Grenze zur darunter liegenden Schicht eine Breite zwischen 125 nm und 175 nm aufweisen. Das Aspektverhältnis beeinflusst in Zusammenwirkung mit den geometrischen Abmessungen des metallischen T-Gates die parasitären Eigenschaften der Transistoren. Transistoren für sehr hohe Frequenzen können ein Aspektverhältnis von bis zu 4:1 aufweisen.

Die Idee der vorliegenden Erfindung besteht darin, dass insbesondere in auf Heteroübergängen basierenden Heterojunction-Transistoren (HFET) die Gate-Struktur durch eine gezielte Kombination mit piezoelektrischen Materialien (z.B. AIN, GaN, InN oder deren ternäre oder quaternäre Verbindungen) in der aktiven Schicht derart modifiziert werden kann, dass eine lokale Reduzierung oder auch eine Inversion des piezoelektrischen Vektors im Bereich unterhalb des Gates erreicht werden kann. Dadurch kann sowohl eine Reduzierung als auch eine Erhöhung der lokalen Elektronendichte im 2DEG innerhalb dieses Bereichs bewirkt werden.

Die Funktionalität des Transistors hängt dabei von der Art der verwendeten Piezomaterialen ab. Beispielsweise erlaubt eine AlGaN/GaN umfassende aktive Schicht eine derart breite Variation der Dichteparameter, dass Transistoren vom Verarmungstyp (D-Transistor), vom Anreichungstyp (E-Transistor) und/oder vom rauscharmen Typ (LN-Typ) (oder auch von entsprechenden Zwischenstufen) in ein und derselben Materialplattform, d.h. ohne eine üblicherweise notwendige lokale strukturelle oder materielle Anpassungen in der aktiven Schicht, alleine durch die piezoelektrischen Eigenschaften der verwendeten Materialien aufgebaut werden können. Eine Abstimmung der elektrischen Eigenschaften dieser Materialien, insbesondere deren elektrischer Polarisation, kann dann durch die gezielte Eintragung mechanischer Spannungen in die aktive Schicht erfolgen. Solche lokalen Materialverspannungen lassen sich durch das Aufbringen und/oder Strukturieren von auf der aktiven Schicht aufliegenden druck- oder zugverspannten dielektrischen Schichten erzeugt. Durch solche externen Verspannungen kann der lokale Polarisationsvektor der darunter liegenden aktiven Schicht beeinflusst werden.

Beispielsweise kann bei einem HFET mit einem AlGaN/GaN-Heteroübergang in der aktiven Schicht eine lokale Zugverspannung in der AlGaN-Schicht (bewirkt durch eine entsprechende Verspannung in den aufliegenden Schichten, welche eine entsprechend "ziehende" Kraftwirkung an der Oberfläche der aktiven Schicht erzeugen) zu einer lokalen Erhöhung der Elektronendichte innerhalb des 2DEG des Transistorkanals an der Grenze zwischen AlGaN-Schicht und der GaN-Schicht führen. Anderseits kann eine entsprechende lokal verdichtende Druckverspannung durch Kompression zu einer lokalen Reduzierung der Elektronendichte im Kanalbereich führen.

Wird die lokale Kompression einer piezoelektrischen Schicht mit einer von einer Schottky-Barriere erzeugten Verarmungszone kombiniert, dann kann auch eine nahezu vollständige Verarmung des Kanalbereichs erzeugt werden, ohne dass hierbei eine Reduzierung der Dicke der epitaktischen Schichten der aktiven Schicht erforderlich ist. Daher werden die Eingangs- und Ausgangswiderstände solcher nicht von den Ansprüchen umfassten selbstsperrenden Transistoren (E-Typ) nicht durch deren Gate-Struktur bzw. die Art der Herstellung beeinflusst. Insbesondere kann zu deren Herstellung auf den Einsatz lokaler Gate-Aussparungen im Halbleitermaterial oder aufwendig zu strukturierende p-Gate-Strukturen gemäß dem Stand der Technik verzichtet werden. Da der Gate-Kanalabstand nicht verändert wird, ändern sich weder die Gate-Kapazität noch die elektrischen Felder in unmittelbarer Umgebung des Gates.

Durch die lokale Einstellung der piezoelektrischen Eigenschaften der aktiven Schicht über eine selektive Strukturierung mit aufgebrachten dielektrischen Schichten können zudem mittels zusätzlicher lokaler Zugverspannung von den Ansprüchen umfasste selbstleitende Transistoren (D-Typ) im gleichen Prozessdurchlauf strukturiert und hergestellt werden. Dadurch wird insbesondere eine gegenüber dem Stand der Technik deutlich vereinfachte E/D-Integration dieser beiden Typen von Transistoren ermöglicht, ohne dass zur Integration lokale Gate-Aussparungen im Halbleitermaterial oder Ionenimplantationsverfahren erforderlich sind.

Wird durch die in die aktive Schicht von oberhalb eingebrachten Verspannungen die Elektronendichte innerhalb des 2DEG des Transistorkanals an der Grenze zwischen AlGaN-Schicht und der GaN-Schicht gerade derart eingestellt, dass das Steilheitsmaximum im Schaltverhalten bei einer Gate-Spannung U_{GS} von 0 V auftritt, so kann ein nicht von den Ansprüchen umfasster, besonderes rauscharm arbeitender Transistor (LN-Transistor) realisiert werden. Die Elektronendichte innerhalb des 2DEG liegt bei einem LN-Transistor somit zwischen den Elektronendichten von E- und D-Transistoren. Hierdurch wird deutlich, dass durch eine entsprechend Einstellung der Verspannungen in der Gate-Umgebung alle drei Transistortypen auf einfache Weise miteinander im gleichen Materialsystem integriert werden können.

Durch die direkte piezoelektrische Beeinflussung des Kanalgebietes kann zur Überwindung der im Stand der Technik auftretenden Nachteile auch bei Kurzkanal-HFETs eine deutliche Verbesserung der elektronischen Eigenschaften erzielt werden. Insbesondere kann durch eine erfindungsgemäße Reduzierung der Polarisationsladungen in der aktiven Schicht eine so starke Reduzierung der Elektronendichte im ausgebildeten 2DEG erreicht werden, dass sich die Verarmungszone unterhalb des Schottky-Gates bis in die Pufferschicht einer konventionellen aktiven Schicht erstreckt, das Auftreten von typischen Kurzkanaleffekten unterdrückt wird und eine einfachere Abschnürung (englisch "pinch-off") des Transistors möglich ist. Eine zusätzliche Verringerung des Abstandes zwischen Kanal und Gate ist hierbei nicht erforderlich.

Die Verwendung piezoelektrischer Materialien zur Änderung der lokalen Elektronendichte innerhalb der aktiven Schicht bzw. innerhalb des Kanalbereichs eines Transistors weist gegenüber dem Stand der Technik insbesondere folgende Vorteile auf:
1) Es sind keine zusätzlichen Schritte zur Erzeugung von Gate-Aussparungen, zur Abstandsreduzierung zwischen Gate und aktiver Schicht oder zur Ionenimplantation notwendig. Daher wird die Kristallstruktur in der aktiven Schicht unterhalb des Gates nicht durch unnötige Materialveränderungen geschädigt, was zu einer Erhöhung der Lebensdauer und der Ausfallsicherheit des Transistors beiträgt.
2) Die Auswirkungen einer lokalen Druck- oder Zugverspannung sind abhängig von der Gate-Länge, so dass gerade bei kurzen Gate-Längen eine Verstärkung des technischen Effektes zu beobachten ist. Insbesondere bei Kurzkanal-HFETs kann hierdurch eine besonders breite Abstimmung der elektronischen Eigenschaften erfolgen. Eine erfindungsgemäße Gate-Struktur eignet sich somit insbesondere für besonders schnell schaltende Transistoren.
3) Da das selbstleitende Verhalten nicht über eine Reduktion des Gate-Kanalabstands eingestellt wird, erhöht sich die Gate-Kapazität von nicht von den Ansprüchen umfassten selbstsperrenden gegenüber von den Ansprüchen umfassten selbstleitenden Transistoren nicht. Das ermöglicht extrem schnell schaltende selbstleitende Transistoren.
4) Das Aufbringen auch unterschiedlich verspannter Schichten ist technologisch recht einfach in bestehende Herstellungsprozesse zu implementieren. Insbesondere werden zur Realisierung keine zusätzlichen weiteren Prozessschritte benötigt.
5) Die epitaktischen Schichten können eine höhere Dicke aufweisen, wodurch die Gesamtkapazität des Gate-Anschlusses reduziert werden kann. Dadurch können die Schaltzeiten der Transistoren weiter gesenkt werden. Eine Integration der verschiedenen Transistortypen kann somit unmittelbar erfolgen.
6) Die epitaktischen Schichten können so gestaltet werden, dass im Zuleitungsbereich zum und vom Gate eine höhere Elektronenkonzentration eingestellt wird. Durch den Einbau einer kompressiv verspannten Passivierungsschicht kann der Bereich unter dem Gate gezielt so eingestellt werden, dass das Steuerverhalten des Gates optimal wird und sich keine Abschnürprobleme einstellen. Auf diese Weise ist es möglich parasitäre Widerstande wie den Source- oder den Drain-Widerstand von Leistungstransistoren zu reduzieren und somit die Effizienz zu erhöhen.
7) Bei der Integration der einzelnen Transistortypen wird der Zuleitungswiderstand von Source zu Gate und von Gate zu Drain bei den selbstsperrenden Transistoren gegenüber der Anwendung herkömmlicher Integrationsmethoden nicht beeinträchtigt.
8) Durch die verbesserte Einstellbarkeit des Schaltverhaltens der erzeugten Transistoren mittels verspannter Schichten kann der Abstand zwischen Gate und Kanal größer sein als bei den bisher im Stand der Technik üblichen Strukturen, d.h. da die elektrischen Felder in der Nähe des Gates mit dem Abstand zum Kanal skalieren, nehmen diese erfindungsgemäß deutlich ab. Das reduziert die auftretenden Leckströme und erhöht die Zuverlässigkeit des Elements. Weiterhin kann durch einen erhöhten Abstand zwischen Gate und Kanal bei den selbstsperrenden Transistoren die Eingangskapazität in der gleichen Größenordnung wie bei den selbstleitenden Transistoren liegen. E/Dintegrierte Schaltungen sind daher insbesondere für Anwendungen im Mikro- und mm-Wellenbereich geeignet.
9) Die technologische Implementierung des Herstellungsverfahrens ist vergleichsweise einfach, kostengünstig und kompatibel zu den meisten Prozesslinien.

In einer nicht von den Ansprüchen umfassten ersten Ausführungsform einer Gate-Struktur kontaktiert das Kontaktelement die aktive Schicht unmittelbar (das Kontaktelement und die aktive Schicht können jedoch auch durch einen dazwischenliegenden Gate-Isolator voneinander getrennt sein), wird zu den Seiten hin von der Passivierungsschicht vollständig umschlossen und von oberhalb der Passivierungsschicht von der Deckschicht überdeckt.

In einer von den Ansprüchen umfassten zweiten Ausführungsform umfasst eine erfindungsgemäße Gate-Struktur weiterhin eine Zwischenschicht, wobei die Zwischenschicht zwischen dem Kontaktelement und der Passivierungsschicht ausgebildet ist. Insbesondere kann durch die Zwischenschicht eine vollständige räumliche Trennung zwischen dem Kontaktelement und der Passivierungsschicht erfolgen. Vorzugsweise bedeckt hierbei die Zwischenschicht die Seitenwände der Ausnehmung der Passivierungsschicht vollständig, wobei zumindest ein Teilbereich des Bodens der Ausnehmung (d.h. der Oberfläche der aktiven Schicht) unmittelbar mit dem Kontaktelement in Verbindung steht. Die Zwischenschicht kann sich bis oberhalb der Passivierungsschicht erstrecken. Insbesondere kann ein sich oberhalb der Passivierungsschicht erstreckender Abschnitt der Zwischenschicht auch zu einer räumlichen Trennung zwischen dem Kontaktelement und der Passivierungsschicht im Bereich oberhalb der Passivierungsschicht beitragen. Bei dieser Ausführungsform kann die Deckschicht insbesondere in den an das Kontaktelement angrenzenden Bereichen auch unmittelbar auf der Zwischenschicht aufliegen und das Kontaktelement von oberhalb überdecken.

Bei der Zwischenschicht kann es sich bevorzugt um eine dielektrische Schicht aus SiNₓ handeln. Ebenfalls bevorzugt sind SiOₓ, SiNₓO_{y}, Al₂O₃, ZnO, Fluorosilicatglas (FSG), Benzozyclobuten (BCB) und Polyimide (PI). Die Dicke der Deckschicht beträgt vorzugsweise zwischen 10 nm und 1000 nm. Bei der Zwischenschicht kann es sich auch um eine Abstandsschicht (englisch "spacer layer") handeln.

Eine nicht von den Ansprüchen umfasste erste Ausführungsform eines E-Transistors weist vorzugsweise eine Gate-Struktur ohne Zwischenschicht auf (nicht von den Ansprüchen umfasste erste Ausführungsform einer Gate-Struktur), wobei die Passivierungsschicht als hochgradig druckverspannte dielektrische Schicht mit einer Normalspannung σ < -1 GPa und die Deckschicht als druckverspannte dielektrische Schicht mit einer Normalspannung σ < -200 MPa ausgebildet sind. Die einzelnen Druckverspannungen in den beiden Schichten wirken zusammen und erzeugen an der Oberfläche der aktiven Schicht eine gerichtete Kraftwirkung, welche über den direkten Piezoeffekt zu einer lokalen Veränderung der elektrischen Polarisation innerhalb der aktiven Schicht führt. Die Stärke dieses Effektes kann dabei u.a. durch die Art der einzelnen Schichtmaterialien (aktive Schicht, Passivierungsschicht, Deckschicht), deren Dickenverhältnis, den geometrischen Abmessungen der einzelnen Strukturelemente und dem jeweiligen Maß der realisierten Druckverspannung eingestellt und kontrolliert werden. Insbesondere kann hierdurch auch eine vollständige Verarmung des Transistorkanals erreicht werden, da der Verarmungsbereich bis in die halbisolierende Pufferschicht einer konventionellen aktiven Schicht reichen kann.

Eine ebenfalls nicht von den Ansprüchen umfasste zweite Ausführungsform eines E-Transistors weist vorzugsweise eine Gate-Struktur mit Zwischenschicht auf (von den Ansprüchen nicht umfasste zweite Ausführungsform einer Gate-Struktur), wobei die Passivierungsschicht als spannungsfreie oder moderat druck- oder moderat zugverspannte dielektrische Schicht mit einer Normalspannung von -1 GPa ≤ σ ≤ 1 GPa, die Zwischenschicht als hochgradig druckverspannte dielektrische Schicht mit einer Normalspannung von σ < -1 GPa und die Deckschicht als druckverspannte dielektrische Schicht mit einer Normalspannung σ < -200 MPa ausgebildet sind. Auch bei dieser Ausführungsform wird über die einzelnen Druckverspannungen die elektrische Polarisation innerhalb der aktiven Schicht lokal verändert. Insbesondere erfolgt ein Eintrag mechanischer Spannungen in die aktive Schicht hierbei hauptsächlich über die Zwischen- und die Deckschicht, während die Passivierungsschicht nur geringen bis keinen Beitrag zum Spannungseintrag liefert.

Eine nicht von den Ansprüchen umfasste erste Ausführungsform eines D-Transistors weist vorzugsweise eine Gate-Struktur ohne Zwischenschicht auf (nicht von den Ansprüchen umfasste erste Ausführungsform einer Gate-Struktur), wobei die Passivierungsschicht als moderat zugverspannte dielektrische Schicht mit einer Normalspannung von 200 MPa < σ ≤ 1 GPa und die Deckschicht als zugverspannte dielektrische Schicht mit einer Normalspannung σ > 200 MPa ausgebildet sind.

Eine von den Ansprüchen umfasste zweite Ausführungsform eines erfindungsgemäßen D-Transistors weist eine erfindungsgemäße Gate-Struktur mit Zwischenschicht auf (von den Ansprüchen umfasste zweite Ausführungsform einer erfindungsgemäßen Gate-Struktur), wobei die Zwischenschicht und die Deckschicht als hochgradig zugverspannte dielektrische Schichten mit Normalspannungen σ > 1 GPa und die Passivierungsschicht als spannungsfreie oder moderat druck- oder moderat zugverspannte dielektrische Schicht mit einer Normalspannung von --1 GPa ≤ σ ≤ 1 GPa ausgebildet sind.

Auch bei den beiden beispielhaft genannten Ausführungsformen eines D-Transistors wirken die einzelnen Verspannungen in den Schichten zusammen und erzeugen an der Oberfläche der aktiven Schicht ebenfalls eine gerichtete Kraftwirkung, welche über den direkten Piezoeffekt zu einer lokalen Veränderung der elektrischen Polarisation innerhalb der aktiven Schicht führt. Auch bei einem D-Transistor kann die Stärke dieses Effektes u.a. durch die Art der einzelnen Schichtmaterialien (aktive Schicht, Passivierungsschicht, Zwischenschicht, Deckschicht), deren Dickenverhältnis, den geometrischen Abmessungen der einzelnen Strukturelemente und dem jeweiligen Maß der realisierten Druckverspannung eingestellt und kontrolliert werden.

Durch die selektive Verspannung mindestens eine oberhalb der aktiven Schicht angeordnete Schicht im Bereich um das Kontaktelement kann die Kraftwirkung an der Oberfläche der aktiven Schicht gezielt im unmittelbaren Bereich um das Kontaktelement beeinflusst werden. Insbesondere kann durch eine lokalen Variation der elektrischen Polarisation innerhalb der aktiven Schicht der Verarmungsbereich unterhalb des Gates gegenüber einem nicht von den Ansprüchen umfassten E-Transistor, welcher auf derselben Epitaxiestruktur basieren kann, reduziert werden, so dass sich hierdurch ein Transistorverhalten vom Verarmungstyp (D-Typ) einstellen lässt.

Eine nicht von den Ansprüchen umfasste erste Ausführungsform eines LN-Transistors weist vorzugsweise eine Gate-Struktur ohne Zwischenschicht auf (nicht von den Ansprüchen umfasste erste Ausführungsform einer Gate-Struktur), wobei die Passivierungsschicht und die Deckschicht als moderat druckverspannte dielektrische Schichten mit Normalspannungen -1 GPa ≤ σ < -200 MPa ausgebildet sind.

Eine ebenfalls nicht von den Ansprüchen umfasste zweite Ausführungsform eines LN-Transistors weist vorzugsweise eine Gate-Struktur mit Zwischenschicht auf (von den Ansprüchen nicht umfasste zweite Ausführungsform einer Gate-Struktur), wobei die Zwischenschicht und die Deckschicht als moderat druckverspannte dielektrische Schichten mit Normalspannungen -1 GPa ≤ σ < -200 MPa ausgebildet sind, und die Passivierungsschicht als spannungsfreie oder moderat zugverspannte dielektrische Schicht mit einer Normalspannung von 0 GPa ≤ σ ≤ 1 GPa ausgebildet sind.

Bei einem LN-Transistor tritt das Steilheitsmaximum im Schaltverhalten bei einer Gate-Spannung U_{GS} von 0 V auf. Bei einem LN-Transistor liegt daher neben den für die einzelnen Ausführungsformen angegebenen Verspannungen in den einzelnen Schichten auch das entsprechende Schaltverhalten eines LN-Transistors vor. Insbesondere sind die Verspannungen in den einzelnen Schichten derart gewählt, dass sich ein entsprechendes Schaltverhalten eines LN-Transistors einstellt.

Ein nicht von den Ansprüchen umfasster weiterer Aspekt der vorliegenden Erfindung betrifft eine Schaltungsanordnung, umfassend mindestens einen E-Transistor und mindestens einen D-Transistor, wobei der E-Transistor und der D-Transistor auf einem gemeinsamen Substrat angeordnet sind (E/D-Integration). Eine solche integrierte Schaltungsanordnung hat u.a. den Vorteil, dass die umfassten selbstleitenden und selbstsperrenden Transistoren insbesondere auf dem gemeinsamen Substrat in ein und derselben Epitaxiestruktur als aktiver Schicht aufgebaut werden können. Eine vom Transistortyp abhängige lokale Veränderung der Epitaxiestruktur durch beispielsweise Ätzen, Abdünnen oder mittels Ionenimplantation ist hierbei nicht erforderlich. Die Unterschiede im Schaltverhalten werden allein durch die auf die aktive Schicht aufgelagerten Schichten über deren lokale mechanische Verspannungen und deren Wechselwirkung mit den piezoelektrischen Polarisationsvektoren innerhalb der aktiven Schicht erzeugt. Der Ausdruck "auf einem gemeinsamen Substrat angeordnet" ist dabei vorzugsweise gleichbedeutend mit "auf einer gemeinsamen aktiven Schicht angeordnet".

Darüber hinaus ermöglich die Erfindung die Realisierung eines D-Transistors in Verbindung mit einem LN-Transistor (D/LN-Integration). LN-Transistoren eignen sich als rauscharme Verstärkerstufen und ermöglichen die monolithische Integration von Empfängern und Sendebausteinen auf einem Chip (Transceiver). Daher betrifft ein weiterer Aspekt der vorliegenden Erfindung eine Schaltungsanordnung, umfassend mindestens einen D-Transistor und mindestens einen LN-Transistor, wobei der D-Transistor und der LN-Transistor auf einem gemeinsamen Substrat angeordnet sind.

Möglich ist jedoch auch die Integration eines E-Transistors in Verbindung mit einem LN-Transistor möglich (E/LN-Integration). Eine entsprechende Schaltungsanordnung umfasst mindestens einen E-Transistor und mindestens einen LN-Transistor, wobei der E-Transistor und der LN-Transistor auf einem gemeinsamen Substrat angeordnet sind.

Für komplexe Schaltungsanordnungen können auch sämtliche bisher genannten Transistortypen auf einer gemeinsamen Substrat- bzw. Epitaxiebasis (E/D/LNA-Integration) integriert werden. Hierbei können neben dem eigentlich Transceiver auch entsprechende Logik-Schaltkreise zur direkten Verarbeitung und Umwandlung der übertragenen Signale mit auf dem Chip integriert werden. Eine entsprechende Schaltungsanordnung, umfassend mindestens einen E-Transistor, mindestens einen D-Transistor und mindestens einem LN-Transistor, wobei die Transistoren auf einem gemeinsamen Substrat angeordnet sind.

Eine nicht von den Ansprüchen umfasste erste Ausführungsform eines Verfahrens zur Herstellung einer Gate-Struktur (Transistor-Struktur) umfasst das Bereitstellen eines Substrats mit einer auf dem Substrat angeordneten piezoelektrischen aktiven Schicht mit einem Heteroübergang; das Aufbringen einer dielektrischen Passivierungsschicht mit einem ersten Verspannungswert auf die aktive Schicht, wobei die Passivierungsschicht eine Dicke zwischen 10 nm und 1000 nm aufweist; das Erzeugen einer Ausnehmung in der Passivierungsschicht, wobei die Ausnehmung sich durch die gesamte Passivierungsschicht hindurch in Richtung der aktiven Schicht erstreckt und an der Grenze zur aktiven Schicht eine Breite zwischen 10 nm und 500 nm aufweist, wobei das Verhältnis zwischen der Dicke der Passivierungsschicht und der Breite der Ausnehmung an der Grenze zur aktiven Schicht zwischen 1,5:1 und 4:1 beträgt; das Ausbilden eines Gate-Kontaktelements, das innerhalb der Ausnehmung angeordnet ist, wobei das Kontaktelement sich von der aktiven Schicht bis oberhalb der Passivierungsschicht erstreckt; und das Aufbringen einer Deckschicht mit einem zweiten Verspannungswert, die das Kontaktelement oberhalb der Passivierungsschicht überdeckt; wobei die Ausbildung mindestens einer oberhalb der aktiven Schicht angeordneten Schicht im Bereich um das Kontaktelement zug- oder druckverspannt mit einer Normalspannung |σ| > 200 MPa erfolgt, wobei über die einzelnen Verspannungen im Bereich um das Kontaktelement eine resultierende Kraft an der Grenzfläche zwischen Passivierungsschicht und aktiver Schicht eingestellt wird, welche über den piezoelektrischen Effekt die Elektronendichte in der aktiven Schicht im Bereich unterhalb des Kontaktelements beeinflusst, wobei die Normalspannungen verspannter Schichten im Bereich zwischen ±4 GPa liegen.

Das Erzeugen einer Ausnehmung in der Passivierungsschicht kann dadurch erfolgen, dass ein geeigneter Lack (englisch "resist") für die Elektronenstrahllithographie oder die optische Lithographie auf die Zwischenschicht aufgetragen wird und mittels eines entsprechenden Lithographieschrittes in der Lackschicht eine Ätzmaske zur Ausbildung der Ausnehmung in der Zwischenschicht erzeugt wird. Bevorzugte Lackmaterialien sind u.a. ZEP 520A, PMMA, PMGI, Copolymere und LOR.

Die Ausnehmung in der Passivierungsschicht kann anschließend durch ein für die Passivierungsschicht geeignetes Strukturierungsverfahren erzeugt werden. Aufgrund der internen Verspannung einer oberhalb der aktiven Schicht angeordneten Schicht wird die Oberfläche der aktiven Schicht im Bereich der unteren Ecken der Ausnehmung jeweils in Abhängigkeit von der Art der Verspannung lokal entweder gedrückt oder gezogen. Durch diese äußere mechanische Belastung aufgrund der eingebrachten Verspannung kann es dabei in der aktiven Schicht zu einer lokalen Verstärkung oder Reduzierung des piezoelektrischen Vektors innerhalb des Materials der aktiven Schicht kommen.

Zu den Vorteilen und technischen Wirkungen des Verfahrens wird auf die entsprechenden Stellen in der Beschreibung zur Gate-Struktur und den davon abgeleiteten Transistortypen bzw. zu deren Integration verwiesen. Die darin genannten Ausführungsformen und deren als bevorzugt angegebenen Merkmale können direkt in das entsprechende Verfahren übernommen werden.

Insbesondere in Strukturen mit einem AlGaN/GaN-Heteroübergang trägt die Polarisation des aktiven Materials eine wesentliche Rolle bei der Ausbildung eines 2DEG, so dass diejenigen Bereiche der aktiven Schicht, welche durch die Belastungseinwirkung aufgrund der mechanischen Verspannung einen veränderten Polarisationsvektor gegenüber ihrer Umgebung aufweisen, mit Ladungsträgern (Elektronen oder Löcher, jeweils abhängig von der ursprünglichen Ausrichtung des piezoelektrischen Vektors in den eingesetzten Materialien und Materialsystemen) angereichert oder verarmt werden.

In einer von den Ansprüchen umfassten zweiten Ausführungsform umfasst das Verfahren zur Herstellung einer Gate-Struktur vor dem Ausbilden eines innerhalb der Ausnehmung angeordneten Kontaktelements weiterhin das Aufbringen einer Zwischenschicht mit einem dritten Verspannungswert innerhalb der Ausnehmung, wobei die Zwischenschicht zwischen dem Kontaktelement und der Passivierungsschicht ausgebildet wird; und das Erzeugen einer zweiten Ausnehmung in der Zwischenschicht, wobei die zweite Ausnehmung sich durch die gesamte Zwischenschicht hindurch in Richtung der aktiven Schicht erstreckt. Das Erzeugen einer Ausnehmung in der Zwischenschicht kann analog zur vorab beschrieben Erzeugen einer Ausnehmung in der Passivierungsschicht erfolgen.

Bei den im Verfahren genannten Verspannungswerten handelt es sich jeweils um die Normalspannungen σ in der Schicht. Eine Nummerierung erfolgte ausschließlich zur besseren Übersicht in Bezug auf die einzelnen Schichten. Insbesondere können nicht durch das Verfahren festgelegte Verspannungswerte beliebige Werte annehmen. Insbesondere kann der Verspannungswert einer Schicht auch den Wert null annehmen (verspannungsfreie Schicht).

Ein nicht von den Ansprüchen umfasster weiterer Aspekt der vorliegenden Erfindung betrifft ein Integrationsverfahren zur Herstellung einer Schaltungsanordnung, wobei mindestens zwei verschiedene Transistortypen (E-, D- oder LN-Transistor) gemäß einem Verfahren auf einem gemeinsamen Substrat hergestellt werden.

### Kurzbeschreibung der Zeichnungen

Die Erfindung wird nachfolgend in Ausführungsbeispielen anhand der zugehörigen Zeichnung erläutert. Es zeigen:
- Fig. 1: einen schematischen Aufbau einer konventionellen Gate-Struktur gemäß dem Stand der Technik,
- Fig. 2: einen schematischen Aufbau einer nicht von den Ansprüchen umfassten ersten Ausführungsform einer Gate-Struktur (E-Transistor),
- Fig. 3: einen schematischen Aufbau einer nicht von den Ansprüchen umfassten zweiten Ausführungsform einer Gate-Struktur (E-Transistor),
- Fig. 4: einen schematischen Aufbau einer nicht von den Ansprüchen umfassten alternativen zweiten Ausführungsform einer Gate-Struktur (E-Transistor),
- Fig. 5: eine schematische Darstellung der spontanen und der piezoelektrischen Polarisationsvektoren im Stand der Technik (links) und der Polarisationsvektoren einer nicht von den Ansprüchen umfassten Ausführungsform einer Gate-Struktur (rechts), und
- Fig. 6: einen schematischen Aufbau einer nicht von den Ansprüchen umfassten Ausführungsform einer Schaltungsanordnung (E/D-Integration).

### Ausführliche Beschreibung der Zeichnungen

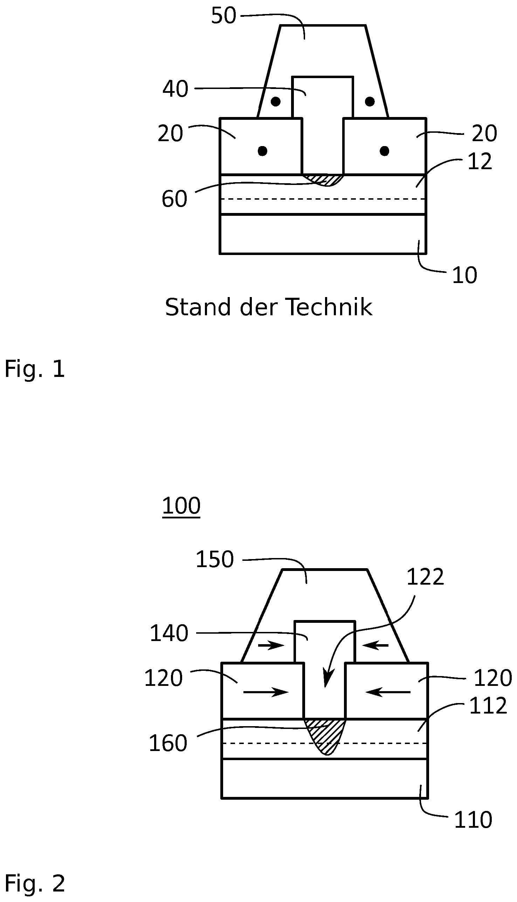

Fig. 1 zeigt einen schematischen Aufbau einer konventionellen Gate-Struktur gemäß dem Stand der Technik. Es handelt sich insbesondere um ein T-Gate, wie es typischerweise in einem HEMT oder HFET genutzt wird. Die Darstellung zeigt eine Gate-Struktur mit einem Substrat 10; einer aktiven Schicht 12, die auf dem Substrat 10 angeordnet ist; einer Passivierungsschicht 20, die auf der aktiven Schicht 12 angeordnet ist, wobei die Passivierungsschicht 20 eine Ausnehmung aufweist, die sich durch die gesamte Passivierungsschicht 20 hindurch in Richtung der aktiven Schicht 12 erstreckt; ein Kontaktelement 40, das innerhalb der Ausnehmung angeordnet ist, wobei das Kontaktelement 40 sich von der aktiven Schicht 12 bis oberhalb der Passivierungsschicht 20 erstreckt; und eine Deckschicht 50, die das Kontaktelement 40 oberhalb der Passivierungsschicht 20 überdeckt.

Die aktive Schicht 12 liegt dabei i.d.R. als vom Substrat getragene Epitaxiestruktur mit besonders hoher Reinheit und Qualität vor. Die Passivierungsschicht 20 und die Deckschicht 50 werden während der anschließenden Strukturierung im Stand der Technik möglichst verspannungsfrei aufgetragen, so dass es zu keinen mechanischen Belastungen in den Materialen kommt. Insbesondere punktuelle Belastungen können die elektrischen Eigenschaften des Transistors stören und sich negativ auf die Produktionsausbeute und die Lebenserwartung der einzelnen Bauteile auswirken. Die Verspannungsfreiheit der Schichten 20, 50 ist durch die eingezeichneten Punkte (verschwindende Verspannungsvektoren) angedeutet.

Weiterhin ist beispielhaft ein typischer Verarmungsbereich 60 eines mit herkömmlicher Technologie auf Basis entspannter dielektrischer Schichten 20, 50 hergestellten AlGaN/GaN HFET gezeigt. Der Verarmungsbereich 60 reicht nur moderat in die aktive Schicht 12 hinein. Um bei gleichen Strukturgrößen eine signifikante Beeinflussung des Verarmungsbereichs 60 zu erreichen, muss bisher i.d.R. in die Epitaxiestruktur der aktiven Schicht, beispielsweise durch strukturelle Veränderungen oder Ionenimplantation, prozesstechnologisch eingegriffen werden. Insbesondere bei Kurzkanal-Transistoren können durch solche Eingriffe auftretende Kurzkanaleffekte (englisch "short-channel effects") abgeschwächt werden. Die üblichen Verfahren zur Einstellung des Verarmungsbereichs 60 sind jedoch sehr zeitaufwendig (zusätzliche Prozessschritte) und können die ursprünglich sehr hohe Qualität der Epitaxieschicht mindern.

Fig. 2 zeigt einen schematischen Aufbau einer nicht von den Ansprüchen umfassten ersten Ausführungsform einer Gate-Struktur. Auch hier kann es sich insbesondere um ein T-Gate für einen HEMT oder HFET handeln. Die Darstellung zeigt eine Gate-Struktur mit einem Substrat 110; einer aktiven Schicht 112, die auf dem Substrat 110 angeordnet ist; einer Passivierungsschicht 120, die auf der aktiven Schicht 112 angeordnet ist, wobei die Passivierungsschicht 120 eine Ausnehmung aufweist, die sich durch die gesamte Passivierungsschicht 120 hindurch in Richtung der aktiven Schicht 112 erstreckt; ein Kontaktelement 140, das innerhalb der Ausnehmung angeordnet ist, wobei das Kontaktelement 140 sich von der aktiven Schicht 112 bis oberhalb der Passivierungsschicht 120 erstreckt; und eine Deckschicht 150, die das Kontaktelement 140 oberhalb der Passivierungsschicht 120 überdeckt, wobei die Passivierungsschicht 120 als hochgradig druckverspannte dielektrische Schicht mit einer Normalspannung σ < -1 GPa ausgebildet ist. Die Deckschicht 150 ist hier ebenfalls als hochgradig druckverspannte dielektrische Schicht mit einer Normalspannung σ < -1 GPa ausgebildet. Insbesondere kann es sich bei der dargestellten Gate-Struktur um eine Gate-Struktur eines E-Transistors 100 handeln (nicht von den Ansprüchen umfasste erste Ausführungsform einer Gate-Struktur). Durch eine Anpassung der Verspannungswerte in den Schichten kann bei gleichbleibendem strukturellem Aufbau jedoch auch das Schaltverhalten eines D-Transistors eingestellt werden.

Die aktive Schicht 112 kann als vom Substrat 110 getragene Epitaxiestruktur mit besonders hoher Reinheit und Qualität vorliegen. Die Passivierungsschicht 120 und die Deckschicht 150 erzeugen an der Oberfläche der aktiven Schicht eine gerichtete Kraftwirkung, welche die Oberfläche der aktiven Schicht vor allem im Bereich der unteren Ecken der Ausnehmung jeweils in Abhängigkeit von der Art der Verspannung entweder drückt oder zieht. Aufgrund der eingezeichneten druckverspannten dielektrische Schichten 120, 150 wird die Oberfläche der aktiven Schicht in diesen Bereichen daher gedrückt, was in Fig. 2 durch die eingezeichneten Verspannungsvektoren verdeutlicht wird.

Die Druckverspannung der Passivierungsschicht 120 führt dazu, dass die Passivierungsschicht 120 jeweils in Richtung der Ausnehmung 122 drückt. Der Verspannungseffekt zeigt damit vor allem Auswirkung im Bereich unterhalb des Gates. Auch wenn, wie bei einem T-Gate, das Material des Kontaktelements 140 (z.B. ein Schottky-Metall) teilweise die Passivierungsschicht 120 überdeckt, bleibt der Verspannungseffekt im Wesentlichen auf den Bereich unterhalb des Gates beschränkt. Ebenfalls ändert das zusätzliche Überdecken des Kontaktelements 140 oberhalb der Passivierungsschicht 120 mit einer ebenfalls druckverspannten dielektrischen Deckschicht 150 nichts an dieser Begrenzung des genutzten Effektes. Durch eine zusätzliche Verspannung der Deckschicht 150 kann der Einfluss der verspannten Passivierungsschicht 120 jedoch weiter verstärkt oder bei Bedarf (durch umgekehrte Polarität des Verspannungsvektors) auch abgeschwächt werden. Die Stärken der einzelnen Verspannungen lassen sich zu einer resultierenden Gesamtkraftwirkung an der Oberfläche der aktiven Schicht 112 zusammenfassen.

Im Vergleich zur Darstellung des in Figur 1 gezeigten typischen Verarmungsbereichs 60 eines mit herkömmlicher Technologie auf Basis entspannter dielektrischer Schichten 20, 50 hergestellten AlGaN/GaN HFET zeigt der Verarmungsbereich 160 einer Gate-Struktur der ersten Ausführungsform mit ansonsten gleichen Parametern eine deutlich effizientere Ladungsträgerverarmung innerhalb des Transistorkanals. Durch die gesteigerte Effektivität der Ladungsträgerverarmung können beispielsweise bei Kurzkanal-Transistoren die ansonsten auftretenden Kurzkanaleffekte auch ohne prozesstechnologische Eingriffe in die aktive Schicht abgeschwächt oder unterdrückt werden. Insbesondere kann durch die Kombination von zwei druckverspannten dielektrischen Schichten 120, 150 auch eine vollständige Verarmung des Transistorkanals erreicht werden. Dies wird möglich, wenn der Verarmungsbereich bis in die halbisolierende Pufferschicht einer konventionellen aktiven Schicht 112 reicht.

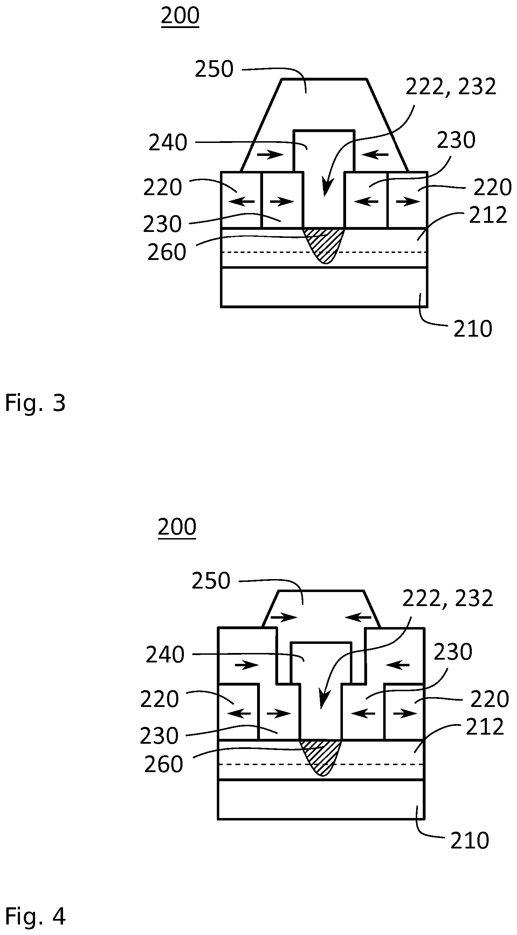

Fig. 3 zeigt einen schematischen Aufbau einer nicht von den Ansprüchen umfassten zweiten Ausführungsform einer Gate-Struktur. Auch hier kann es sich insbesondere um ein T-Gate für einen HEMT oder HFET handeln. Die Darstellung zeigt eine Gate-Struktur mit einem Substrat 210; einer aktiven Schicht 212, die auf dem Substrat 210 angeordnet ist; einer Passivierungsschicht 220, die auf der aktiven Schicht 212 angeordnet ist, wobei die Passivierungsschicht 220 eine Ausnehmung aufweist, die sich durch die gesamte Passivierungsschicht 220 hindurch in Richtung der aktiven Schicht 212 erstreckt; ein Kontaktelement 240, das innerhalb der Ausnehmung angeordnet ist, wobei das Kontaktelement 240 sich von der aktiven Schicht 212 bis oberhalb der Passivierungsschicht 220 erstreckt; und eine Deckschicht 250, die das Kontaktelement 240 oberhalb der Passivierungsschicht 220 überdeckt, wobei die Passivierungsschicht 220 als spannungsfreie oder moderat druck- oder moderat zugverspannte dielektrische Schicht mit einer Normalspannung von -1 GPa ≤ σ ≤ 1 GPa ausgebildet ist. Die dargestellte Gate-Struktur weist weiterhin eine Zwischenschicht 230 auf, wobei die Zwischenschicht 230 zwischen dem Kontaktelement 240 und der Passivierungsschicht 220 ausgebildet ist. Die Zwischenschicht 230 ist als hochgradig druckverspannte dielektrische Schicht mit einer Normalspannung von σ < -1 GPa ausgebildet. Die Deckschicht 250 ist als druckverspannte dielektrische Schicht mit einer Normalspannung σ < -200 MPa ausgebildet. Insbesondere kann es sich bei der dargestellten Gate-Struktur um die Gate-Struktur eines E-Transistors 200 handeln (nicht von den Ansprüchen umfasste zweite Ausführungsform einer Gate-Struktur). Durch eine Anpassung der Verspannungswerte in den Schichten kann bei gleichbleibendem strukturellem Aufbau jedoch auch das Schaltverhalten eines erfindungsgemäßen D-Transistors eingestellt werden.

Der Aufbau der aktiven Schicht 212 sowie die Beschreibungen zur Wirkung der einzelnen Verspannungen kann analog der entsprechenden Beschreibung zur Figur 2 entnommen werden. Im Bereich der Zwischenschicht 230 kommt jedoch die Druckverspannung zum Tragen, deren Wirkungen auf die aktive Schicht 212 sich im Allgemeinen genau umgekehrt zu den Wirkungen einer Zugverspannung verhalten. Aufgrund der druckverspannten Zwischenschicht 230 wird die Oberfläche der aktiven Schicht 212 vor allem im Bereich der unteren Ecken der zweiten Ausnehmung 232 mechanisch verspannt, was auch in Fig. 3 durch die eingezeichneten Verspannungsvektoren verdeutlicht wird.

Die Druckverspannung der Zwischenschicht 230 führt dazu, dass die Zwischenschicht 230 jeweils in Richtung der Ausnehmung 232 drückt. Auch hier zeigt der Verspannungseffekt vor allem Auswirkung im Bereich unterhalb des Gates. Auch das zusätzliche Überdecken des Kontaktelements 240 oberhalb der Passivierungsschicht 220 mit einer ebenfalls druckverspannten dielektrischen Deckschicht 250 ändert nichts an dieser Begrenzung des ausgenutzten Effektes. Durch eine zusätzliche Verspannung der Deckschicht 250 kann der Effekt der verspannten Passivierungsschicht 220 jedoch nochmals verstärkt oder bei Bedarf (durch umgekehrte Polarität des Verspannungsvektors) auch abgeschwächt werden. Die Stärken der einzelnen Verspannungen lassen sich auch bei dieser Ausführungsform einer Gate-Struktur zu einer resultierenden Gesamtkraftwirkung an der Oberfläche der aktiven Schicht 212 zusammenfassen.

Im Vergleich zur Darstellung des in Figur 2 gezeigten Verarmungsbereichs 160 einer Gate-Struktur der ersten Ausführungsform zeigt der Verarmungsbereich 260 einer Gate-Struktur der zweiten Ausführungsform bei ansonsten gleichen Parametern eine ähnlich effiziente Möglichkeit zur Steuerung der Ladungsträgerverarmung innerhalb des Transistorkanals. Durch die Druckverspannung der dielektrischen Zwischenschicht 230 kann eine vollständige Verarmung des Transistorkanals erreicht werden (E-Transistor). Diese Möglichkeit zur Steuerung der Ladungsträgerverarmung ist insbesondere im Rahmen einer E/D-Integration von Vorteil, da somit E- und D-Transistoren ohne prozesstechnologische Eingriffe in die aktive Schicht auf einem gemeinsamen Substrat in derselben Epitaxiestruktur als aktiver Schicht 212 aufgebaut werden können.

Fig. 4 zeigt einen schematischen Aufbau einer nicht von den Ansprüchen umfassten alternativen zweiten Ausführungsform einer Gate-Struktur. Die gezeigte Darstellung entspricht weitestgehend der in Figur 3 gezeigten Darstellung, die Bezugszeichen und deren Zuordnung gelten entsprechend. Im Unterschied zu Figur 3 erstreckt sich bei der dargestellten Gate-Struktur die Zwischenschicht 230 bis oberhalb der Passivierungsschicht 220 und liegt zumindest teilweise auch auf dieser auf. Dadurch kann insbesondere eine mögliche Zugverspannung der darunterliegenden Passivierungsschicht 220 zumindest teilweise kompensiert werden, so dass die geometrische Ausformung der Zwischenschicht 230 ebenfalls als zusätzlicher Abstimmungsparameter in Betracht kommt.

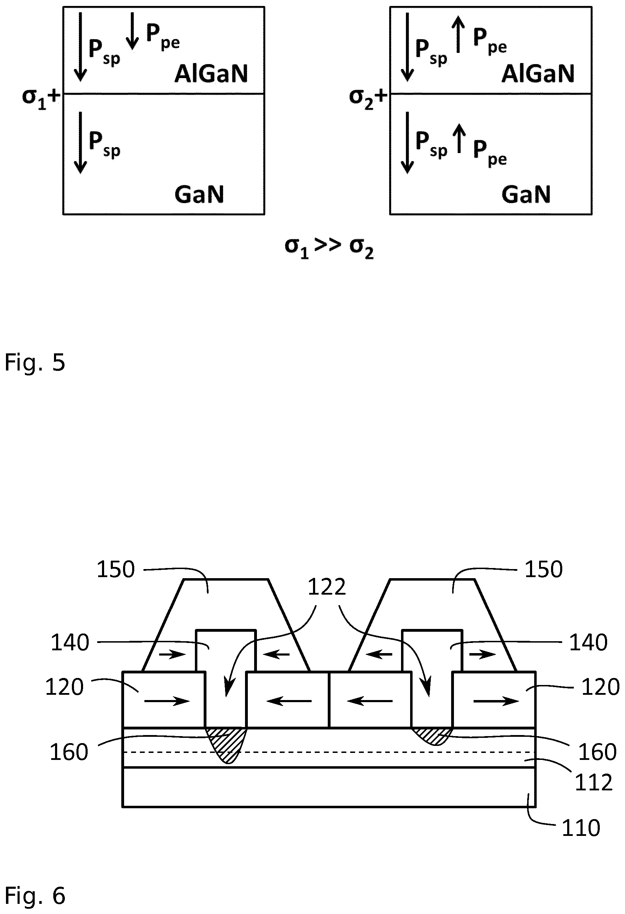

Fig. 5 zeigt eine schematische Darstellung der spontanen und der piezoelektrischen Polarisationsvektoren im Stand der Technik und der Polarisationsvektoren einer nicht von den Ansprüchen umfassten Ausführungsform einer Gate-Struktur. Hierbei kann es sich insbesondere um einen Transistor mit einem Ga-seitigen AlGaN/GaN-Heteroübergang in der aktiven Schicht handeln. Wenn keine externen Kräfte durch Verspannung von außen auf die aktive Schicht einwirken (links), dann kann es aufgrund der Gitterfehlanpassung mit GaN zu einer intrinsischen Zugverspannung des AlGaN kommen. Die GaN-Schicht ist hingegen durch eine vergleichsweise hohe Materialdicke (typischerweise zwischen 1 µm bis 6 µm) i.d.R. jedoch verspannungsfrei. In diesem Fall kann in der GaN-Schicht lediglich ein spontaner Polarisationsvektor definiert werden, während in der zugverspannten AlGaN-Schicht der spontane und der piezoelektrische Polarisationsvektor kollinear ausgerichtet sind.

Wenn nun zusätzlich eine externe Druckverspannung auf die aktive Schicht einwirkt (rechts), dann kann der piezoelektrische Polarisationsvektor in der AlGaN-Schicht lokal abgeschwächt oder sogar invertiert werden. Dadurch wird die Gesamtpolarisation in der AlGaN-Schicht abgeschwächt, was dazu führt, dass weniger Polarisationsladungen am AlGaN/GaN-Heteroübergang vorhanden sind. Durch die Druckverspannung wird jedoch auch die GaN-Schicht lokal verdichtet, so dass durch den dadurch erzeugten zusätzlichen Polarisationsvektor die Gesamtpolarisation am AlGaN/GaN-Heteroübergang weiter herabgesetzt wird. Die dadurch bedingte lokale Verringerung der Polarisationsladungen am AlGaN/GaN-Heteroübergang bewirkt wiederum eine Reduzierung der Elektronendichte σ im 2DEG, was zu einer Ausweitung des Verarmungsbereichs unterhalb eines Schottky-Gates bis in die Pufferschicht einer konventionellen aktiven Schicht führen kann. Wenn die druckinduzierte Verspannung bis in die GaN-Pufferschicht reicht, kann sich der Effekt unter Umständen jedoch auch aufheben, da die Elektronendichte im Kanal vom Unterschied der Summen der jeweiligen Polarisationsladungen im AlGaN und GaN abhängt. Wenn das GaN und das AlGaN in gleicher Weise druckverspannt sind und sich die spontanen und der piezoelektrischen Piezokoeffizienten ähneln, dann ist kein Effekt zu beobachten oder dieser ist nur gering. Die Piezokonstanten in AlGaN sind allerdings höher als die des GaN, so dass sich der Effekt eher abschwächt. Es ist jedoch bevorzugt, dass die aktive Schicht selbst spannungsfrei ist.

Im Übrigen zeigen die piezoelektrischen Polarisationsvektoren bei einer externen Zugverspannung an der Oberfläche der aktiven Schicht ein ganz analoges umgekehrtes Verhalten. Eine lokale Erhöhung der Polarisationsladungen am AlGaN/GaN-Heteroübergang bewirkt hier eine Steigerung der Elektronendichte σ im 2DEG. Die Erstreckung des Verarmungsbereichs unterhalb eines Schottky-Gates kann somit gegenüber einem baugleichen verspannungsfreien Design reduziert werden. Dadurch wird eine flexible lokale Kontrolle der Elektronendichte σ im 2DEG unterhalb des Transistor-Gates ermöglicht, was insbesondere zur einfachen E/D-Integration genutzt werden kann.

Fig. 6 zeigt einen schematischen Aufbau einer Ausführungsform einer nicht von den Ansprüchen umfassten Schaltungsanordnung. Insbesondere handelt es sich hierbei um eine E/D-Integration, bei der ein E-Transistor 100, insbesondere eine erste Ausführungsform eines E-Transistors 100 entsprechend Fig. 2 (mit einer nicht von den Ansprüchen umfassten Gate-Struktur ohne Zwischenschicht 230), und ein D-Transistor, insbesondere eine erste Ausführungsform eines D-Transistors (nicht von den Ansprüchen umfasste Gate-Struktur ohne Zwischenschicht 230) auf einem gemeinsamen Substrat 110 angeordnet sind. Da sich die entsprechenden Ausführungsformen der beiden Transistoren strukturell nicht voneinander unterscheiden, entsprechen die Bezugszeichen und deren jeweilige Zuordnung den in der Beschreibung zu Fig. 2 gemachten Angaben.

Der vorliegenden Darstellung ist insbesondere anhand der eingezeichneten Verarmungszonen 160 zu entnehmen, dass durch eine Variation der Verspannungen in den einzelnen Schichten das Schaltverhalten benachbarter Transistoren geändert werden kann, ohne dass ein zusätzlicher Strukturierungsaufwand zur lokalen Beeinflussung der Elektronendichte innerhalb der aktiven Schicht 112 notwendig ist. Somit kann eine E/D-Integration auf einem gemeinsamen Substrat 100 bzw. auf einer gemeinsamen aktiven Schicht 112 erfolgen. Entsprechend kann die Schaltungsanordnung auch die Integration LN-Transistoren mit E- bzw. D-Transistoren 100 oder eine gemeinsame Integration aller aufgeführten Transistortypen umfassen. Die Verwendung von Ausführungsformen mit oder ohne Zwischenschicht 230 ergibt sich dabei aus den jeweils geforderten Verspannungswerten an den einzelnen Gate-Strukturen und aus Vorgaben zu den verwendeten Schichtsystemen.

### Bezugszeichenliste

- 10: Substrat
- 12: aktive Schicht
- 20: Passivierungsschicht
- 40: Kontaktelement
- 50: Deckschicht
- 60: Verarmungsbereich
- 100: E-Transistor
- 110: Substrat
- 112: aktive Schicht
- 120: Passivierungsschicht
- 122: Ausnehmung
- 140: Kontaktelement
- 150: Deckschicht
- 160: Verarmungsbereich
- 200: E-Transistor
- 210: Substrat
- 212: aktive Schicht
- 220: Passivierungsschicht
- 222: Ausnehmung
- 230: Zwischenschicht
- 232: zweite Ausnehmung
- 240: Kontaktelement
- 250: Deckschicht
- 260: Verarmungsbereich

## Patentansprüche

1. D-Transistor mit einer Transistor-Struktur, aufweisend:
a) ein Substrat (110, 210);
b) eine piezoelektrische aktive Schicht (112, 212) mit einem Heteroübergang, die auf dem Substrat (110, 210) angeordnet ist;
c) eine dielektrische Passivierungsschicht (120, 220), die auf der aktiven Schicht (112, 212) angeordnet ist und eine Dicke zwischen 10 nm und 1000 nm aufweist, wobei die Passivierungsschicht (120, 220) eine Ausnehmung (122, 222) aufweist, die sich durch die gesamte Passivierungsschicht (120, 220) hindurch in Richtung der aktiven Schicht (112, 212) erstreckt, wobei die Ausnehmung (122, 222) an der Grenze zur aktiven Schicht (112, 212) eine Breite zwischen 10 nm und 500 nm aufweist und das Verhältnis zwischen der Dicke der Passivierungsschicht (120, 220) und der Breite der Ausnehmung (122, 222) an der Grenze zur aktiven Schicht (112, 212) zwischen 1,5:1 und 4:1 beträgt;
d) ein Gate-Kontaktelement (140, 240), das innerhalb der Ausnehmung (122, 222) angeordnet ist, wobei das Kontaktelement (140, 240) sich von der aktiven Schicht (112, 212) bis oberhalb der Passivierungsschicht (120,220) erstreckt;
e) eine Zwischenschicht (230), wobei die Zwischenschicht (230) zwischen dem Kontaktelement (240) und der Passivierungsschicht (220) ausgebildet ist; und
f) eine Deckschicht (150, 250), die das Kontaktelement (140, 240) oberhalb der Passivierungsschicht (120, 220) überdeckt;
g) wobei mindestens eine oberhalb der aktiven Schicht (112, 212) angeordnete Schicht (120, 220, 150, 250, 230) im Bereich um das Kontaktelement (140, 240) zug- oder druckverspannt mit einer Normalspannung |σ| > 200 MPa ausgebildet ist,
h) wobei über die einzelnen Verspannungen im Bereich um das Kontaktelement (140, 240) eine resultierende Kraft an der Grenzfläche zwischen Passivierungsschicht (120, 220) und aktiver Schicht (112, 212) eingestellt ist, welche über den piezoelektrischen Effekt die Elektronendichte in der aktiven Schicht (112, 212) im Bereich unterhalb des Kontaktelements (140, 240) beeinflusst, wobei die Normalspannungen verspannter Schichten im Bereich zwischen ±4 GPa liegen,
**dadurch gekennzeichnet, dass**
i) die Zwischenschicht (230) und die Deckschicht (250) als hochgradig zugverspannte dielektrische Schichten mit Normalspannungen σ > 1 GPa und die Passivierungsschicht (220) als spannungsfreie oder moderat druck- oder moderat zugverspannte dielektrische Schicht mit einer Normalspannung von -1 GPa ≤ σ ≤ 1 GPa ausgebildet sind.

2. Verfahren zur Herstellung eines D-Transistors mit einer Transistor-Struktur, folgende Schritte umfassend:
a) Bereitstellen eines Substrats (110, 210) mit einer auf dem Substrat (110, 210) angeordneten piezoelektrischen aktiven Schicht (112, 212) mit einem Heteroübergang;
b) Aufbringen einer dielektrischen Passivierungsschicht (120, 220) mit einem ersten Verspannungswert auf die aktive Schicht (112, 212), wobei die Passivierungsschicht (120, 220) eine Dicke zwischen 10 nm und 1000 nm aufweist;
c) Erzeugen einer Ausnehmung (122, 222) in der Passivierungsschicht (120, 220), wobei die Ausnehmung (122, 222) sich durch die gesamte Passivierungsschicht (120, 220) hindurch in Richtung der aktiven Schicht (112, 212) erstreckt und an der Grenze zur aktiven Schicht (112, 212) eine Breite zwischen 10 nm und 500 nm aufweist, wobei das Verhältnis zwischen der Dicke der Passivierungsschicht (120, 220) und der Breite der Ausnehmung (122, 222) an der Grenze zur aktiven Schicht (112, 212) zwischen 1,5:1 und 4:1 beträgt;
d) Aufbringen einer Zwischenschicht (230) mit einer dritten Verspannung innerhalb der Ausnehmung (222), wobei die Zwischenschicht (230) zwischen einem auszubildenden Gate-Kontaktelement (140, 240) und der Passivierungsschicht (220) ausgebildet wird;
e) Erzeugen einer zweiten Ausnehmung (232) in der Zwischenschicht (230), wobei die zweite Ausnehmung (232) sich durch die gesamte Zwischenschicht (230) hindurch in Richtung der aktiven Schicht (212) erstreckt;
f) Ausbilden des Gate-Kontaktelements (140, 240), das innerhalb der zweiten Ausnehmung (232) angeordnet ist, wobei das Kontaktelement (140, 240) sich von der aktiven Schicht (112, 212) bis oberhalb der Passivierungsschicht (120, 220) erstreckt;
g) Aufbringen einer Deckschicht (150, 250) mit einem zweiten Verspannungswert, die das Kontaktelement (140, 240) oberhalb der Passivierungsschicht (120, 220) überdeckt;
h) wobei die Ausbildung mindestens einer oberhalb der aktiven Schicht (112, 212) angeordneten Schicht (120, 220, 150, 250) im Bereich um das Kontaktelement (140, 240) zug- oder druckverspannt mit einer Normalspannung |σ| > 200 MPa erfolgt, wobei über die einzelnen Verspannungen im Bereich um das Kontaktelement (140, 240) eine resultierende Kraft an der Grenzfläche zwischen Passivierungsschicht (120, 220) und aktiver Schicht (112, 212) eingestellt wird, welche über den piezoelektrischen Effekt die Elektronendichte in der aktiven Schicht (112, 212) im Bereich unterhalb des Kontaktelements (140, 240) beeinflusst, wobei die Normalspannungen verspannter Schichten im Bereich zwischen ±4 GPa liegen,
**dadurch gekennzeichnet, dass**
i) die Zwischenschicht (230) und die Deckschicht (250) als hochgradig zugverspannte dielektrische Schichten mit Normalspannungen σ > 1 GPa und die Passivierungsschicht (220) als spannungsfreie oder moderat druck- oder moderat zugverspannte dielektrische Schicht mit einer Normalspannung von -1 GPa ≤ σ ≤ 1 GPa ausgebildet sind.

## Claims

1. D-transistor with a transistor structure, comprising:
a) a substrate (110, 210);
b) a piezoelectric active layer (112, 212) with a heterojunction arranged on the substrate (110, 210);
c) a dielectric passivation layer (120, 220) arranged on the active layer (112, 212) and having a thickness between 10 nm and 1,000 nm, wherein the passivation layer (120, 220) has a recess (122, 222) extending through the entire passivation layer (120, 220) towards the active layer (112, 212), wherein the recess (122, 222) has a width between 10 nm and 500 nm at the boundary with the active layer (112, 212) and the ratio between the thickness of the passivation layer (120, 220) and the width of the recess (122, 222) at the boundary with the active layer (112, 212) is between 1.5:1 and 4:1;
d) a gate contact element (140, 240) arranged within the recess (122, 222), wherein the contact element (140, 240) extends from the active layer (112, 212) to above the passivation layer (120, 220);
e) an intermediate layer (230), wherein the intermediate layer (230) is formed between the contact element (240) and the passivation layer (220); and
f) a cover layer (150, 250) that covers the contact element (140, 240) above the passivation layer (120, 220);
g) wherein at least one layer (120, 220, 150, 250, 230) arranged above the active layer (112, 212) is tensile-stressed or compressively stressed in the area around the contact element (140, 240) with a normal stress of |σ| > 200 MPa,
h) wherein a resultant force is applied at the interface between the passivation layer (120, 220) and the active layer (112, 212) via the individual stresses in the area around the contact element (140, 240), which influences the electron density in the active layer (112, 212) in the area below the contact element (140, 240) via the piezoelectric effect, wherein the normal stresses of stressed layers are in the range between ±4 GPa,
**characterized in that**
i) the intermediate layer (230) and the top layer (250) are formed as highly tensile-stressed dielectric layers with normal stresses of σ > 1 GPa, and the passivation layer (220) is formed as a stress-free or moderately compressively or moderately tensile-stressed dielectric layer with a normal stress of -1 GPa < σ < 1 GPa.

2. A method for fabricating a D-transistor with a transistor structure, comprising the following steps:
a) providing a substrate (110, 210) with a piezoelectric active layer (112, 212) having a heterojunction arranged on the substrate (110, 210);
b) applying a dielectric passivation layer (120, 220) with a first stress value to the active layer (112, 212), wherein the passivation layer (120, 220) has a thickness between 10 nm and 1000 nm;
c) creating a recess (122, 222) in the passivation layer (120, 220), wherein the recess (122, 222) extends through the entire passivation layer (120, 220) towards the active layer (112, 212) and has a width between 10 nm and 500 nm at the boundary with the active layer (112, 212), wherein the ratio between the thickness of the passivation layer (120, 220) and the width of the recess (122, 222) at the boundary with the active layer (112, 212) is between 1.5:1 and 4:1;
d) applying an intermediate layer (230) with a third stress value within the recess (222), wherein the intermediate layer (230) is formed between a gate contact element (140, 240) to be formed and the passivation layer (220);
e) creating a second recess (232) in the intermediate layer (230), wherein the second recess (232) extends through the entire intermediate layer (230) towards the active layer (212);
f) forming the gate contact element (140, 240) arranged within the second recess (232), wherein the contact element (140, 240) extends from the active layer (112, 212) to above the passivation layer (120, 220);
g) applying a cover layer (150, 250) with a second stress value, which covers the contact element (140, 240) above the passivation layer (120, 220);
h) wherein at least one layer (120, 220, 150, 250) arranged above the active layer (112, 212) is tensile-stressed or compressively stressed in the area around the contact element (140, 240) with a normal stress of |σ| > 200 MPa, wherein a resultant force is applied at the interface between the passivation layer (120, 220) and the active layer (112, 212) via the individual stresses in the area around the contact element (140, 240), which influences the electron density in the active layer (112, 212) in the area below the contact element (140, 240) via the piezoelectric effect, wherein the normal stresses of the stressed layers are in the range between ±4 GPa,
**characterized in that**
i) the intermediate layer (230) and the top layer (250) are formed as highly tensile-stressed dielectric layers with normal stresses of σ > 1 GPa, and the passivation layer (220) is formed as a stress-free or moderately compressively or moderately tensile-stressed dielectric layer with a normal stress of -1 GPa < σ < 1 GPa.

## Revendications

1. D-Transistor avec une structure de transistor, comportant :
a) un substrat (110, 210) ;
b) une couche active piézoélectrique (112, 212) avec une hétérojonction, disposée sur le substrat (110, 210) ;
c) une couche de passivation diélectrique (120, 220) disposée sur la couche active (112, 212) et présentant une épaisseur comprise entre 10 nm et 1000 nm, la couche de passivation (120, 220) présentant un évidement (122, 222) qui s'étend à travers toute la couche de passivation (120, 220) en direction de la couche active (112, 212), l'évidement (122, 222) présentant une largeur comprise entre 10 nm et 500 nm à la limite avec la couche active (112, 212) et le rapport entre l'épaisseur de la couche de passivation (120, 220) et la largeur de l'évidement (122, 222) à la limite avec la couche active (112, 212) est compris entre 1,5:1 et 4:1 ;
d) un élément de contact de grille (140, 240) disposé à l'intérieur de l'évidement (122, 222), l'élément de contact (140, 240) s'étendant depuis la couche active (112, 212) jusqu'au-dessus de la couche de passivation (120, 220) ;
e) une couche intermédiaire (230), la couche intermédiaire (230) étant formée entre l'élément de contact (240) et la couche de passivation (220) ; et
f) une couche de recouvrement (150, 250) qui recouvre l'élément de contact (140, 240) au-dessus de la couche de passivation (120, 220) ;
g) au moins une couche (120, 220, 150, 250, 230) disposée au-dessus de la couche active (112, 212) étant formée dans la zone autour de l'élément de contact (140, 240) soumise à une contrainte de traction ou de compression avec une contrainte normale |σ| > 200 MPa,
h) une force résultante étant réglée à l'interface entre la couche de passivation (120, 220) et la couche active (112, 212) par l'intermédiaire des contraintes individuelles dans la zone autour de l'élément de contact (140, 240), laquelle influence la densité d'électrons dans la couche active (112, 212) dans la zone située sous l'élément de contact (140, 240), les contraintes normales des couches contraintes se situant dans la plage comprise entre ±4 GPa,
**caractérisé en ce que**
i) la couche intermédiaire (230) et la couche de recouvrement (250) sont conçues comme des couches diélectriques fortement contraintes en traction avec des contraintes normales σ > 1 GPa et la couche de passivation (220) comme une couche diélectrique sans contrainte ou modérément contrainte en compression ou modérément contrainte en traction avec une contrainte normale de -1 GPa < σ < 1 GPa.

2. Procédé de fabrication d'un D-Transistor avec une structure de transistor, comprenant les étapes suivantes :
a) fourniture d'un substrat (110, 210) comportant une couche active piézoélectrique (112, 212) avec une hétérojonction disposée sur le substrat (110, 210) ;
b) application d'une couche de passivation diélectrique (120, 220) avec une première valeur de contrainte sur la couche active (112, 212), la couche de passivation (120, 220) présentant une épaisseur comprise entre 10 nm et 1000 nm ;
c) création d'un évidement (122, 222) dans la couche de passivation (120, 220), ledit évidement (122, 222) s'étendant à travers toute la couche de passivation (120, 220) en direction de la couche active (112, 212) et présentant, à la limite avec la couche active (112, 212), une largeur comprise entre 10 nm et 500 nm, le rapport entre l'épaisseur de la couche de passivation (120, 220) et la largeur de l'évidement (122, 222) à la limite avec la couche active (112, 212) étant comprise entre 1,5:1 et 4:1 ;
d) application d'une couche intermédiaire (230) avec une troisième contrainte à l'intérieur de l'évidement (222), la couche intermédiaire (230) étant formée entre un élément de contact de grille (140, 240) à former et la couche de passivation (220) ;
e) formation d'un deuxième évidement (232) dans la couche intermédiaire (230), le deuxième évidement (232) s'étendant à travers toute la couche intermédiaire (230) en direction de la couche active (212) ;
f) formation de l'élément de contact de grille (140, 240) disposé à l'intérieur du deuxième évidement (232), l'élément de contact (140, 240) s'étendant depuis la couche active (112, 212) jusqu'au-dessus de la couche de passivation (120, 220) ;
g) application d'une couche de recouvrement (150, 250) présentant une deuxième valeur de contrainte, qui recouvre l'élément de contact (140, 240) au-dessus de la couche de passivation (120, 220) ;
h) la formation d'au moins une couche (120, 220, 150, 250) disposée au-dessus de la couche active (112, 212) dans la zone autour de l'élément de contact (140, 240) étant réalisée sous traction ou compression avec une contrainte normale |σ| > 200 MPa, les différentes contraintes dans la zone autour de l'élément de contact (140, 240) permettant d'établir une force résultante à l'interface entre la couche de passivation (120, 220) et la couche active (112, 212), laquelle influence, par l'effet piézoélectrique, la densité électronique dans la couche active (112, 212) dans la zone située sous l'élément de contact (140, 240), les contraintes normales des couches contraintes se situant dans une plage comprise entre ±4 GPa, **caractérisé en ce que**
i) la couche intermédiaire (230) et la couche de recouvrement (250) sont conçues comme des couches diélectriques fortement contraintes en traction avec des contraintes normales σ > 1 GPa et la couche de passivation (220) comme une couche diélectrique sans contrainte ou modérément contrainte en compression ou modérément contrainte en traction avec une contrainte normale de -1 GPa < σ < 1 GPa.
